# FASCICULE DE BREVET EUROPEEN

(11) **EP 3 332 548 B1**
(45) Date de publication et mention de la délivrance du brevet: **15.04.2020**
(21) Numéro de dépôt: 16745728.2
(22) Date de dépôt: 29.07.2016
(51) Int. Cl.: H04N 5/355, H04N 5/3745, H04N 5/374, H01L 27/146

(54) **PROCÉDÉ DE COMMANDE D'UN CAPTEUR D'IMAGE À PIXELS ACTIFS**
VERFAHREN ZUR STEUERUNG EINES AKTIVEN PIXELBILDSENSORS
METHOD FOR CONTROLLING AN ACTIVE PIXEL IMAGE SENSOR

(30) Priorité: 03.08.2015 FR 1557460
(43) Date de publication de la demande: 13.06.2018
(73) Titulaire: Teledyne e2v Semiconductors SAS, 38120 Saint-Egrève (FR)
(72) Inventeur: MAYER, Frédéric, 38500 Voiron (FR); BARBIER, Frédéric, 38120 Fontanil-Cornillon (FR); GESSET, Stéphane, 38380 Saint Laurent du Pont (FR)
(74) Mandataire: Lucas, Laurent Jacques
(86) Numéro de dépôt international: PCT/EP2016/068221
(87) Numéro de publication internationale: WO 2017/021328

(56) Documents cités:
- EP-A1- 2 634 595
- EP-A2- 2 247 093
- US-A1- 2011 019 045
- US-A1- 2014 247 378

## Description

### DOMAINE TECHNIQUE

L'invention concerne les capteurs d'image électronique fonctionnant à partir de pixels actifs en technologie MOS. Plus précisément, l'invention concerne un procédé de commande des différents transistors qui constituent le pixel actif.

### ETAT DE LA TECHNIQUE

Les pixels actifs comprennent le plus souvent une photodiode transformant en charges électriques les photons reçus, et plusieurs transistors MOS permettant de contrôler la lecture de ces charges et leur conversion en tension électrique. Dans un capteur matriciel, les lignes de pixels sont adressées individuellement et les tensions issues des pixels sont appliquées à des conducteurs de colonne communs aux pixels d'une même colonne. Des circuits de lecture en pied de colonne permettent de lire et convertir en numérique les tensions présentes sur les colonnes. Par exemple, on échantillonne, pour chaque ligne de pixels adressée, les tensions présentes sur les colonnes. Les échantillons sont stockés dans des capacités du circuit de lecture. Les échantillons sont ensuite convertis en numérique par un convertisseur analogique-numérique (par exemple un convertisseur pour chaque colonne de pixels).

Les pixels actifs utilisant une photodiode comprennent généralement au moins quatre transistors : un transistor de transfert sert à déverser les charges de la photodiode vers un nœud dit de lecture, qui est un nœud capacitif de stockage de charges ; un transistor de lecture qui est monté en suiveur de tension et dont la grille est reliée au nœud de lecture pour établir sur sa source une tension représentant la tension de ce nœud ; un transistor de sélection de ligne commandé par un conducteur de ligne pour sélectionner toute une ligne de pixels et relier la sortie du transistor suiveur de chaque pixel au conducteur de colonne correspondant à ce pixel et par là, au circuit de lecture en pied de colonne ; et un transistor de réinitialisation permettant de rétablir le potentiel du nœud de lecture à une valeur de référence.

La mesure de la quantité de charges générée par la photodiode est obtenue en faisant la différence entre le niveau de potentiel du nœud de lecture obtenu après le transfert, et le niveau de potentiel de référence après ré-initialisation du nœud de lecture.

Les structures de pixels actifs peuvent être commandées de différentes manières. En particulier, la capture des images peut se faire en utilisant la technique dite "global shutter" où tous les pixels intègrent des charges générées par la lumière pendant une période d'intégration qui est la même pour tous. Ensuite les pixels sont lus ligne par ligne. Dans la technique de capture à fenêtre glissante dite "rolling shutter", la période d'intégration est décalée dans le temps d'une ligne de pixels à l'autre.

La technique "global shutter" permet notamment d'éviter des effets de distorsion lorsque l'on capture des images d'objets en mouvement.

Dans une structure de pixel actif à quatre ou cinq transistors, le séquencement de la phase d'intégration commune à tous les pixels est le suivant :
- le temps d'une impulsion de commande d'initialisation, on force l'évacuation des charges dans toutes les photodiodes. La fin de l'impulsion fixe le début de la durée d'intégration des photodiodes : elles peuvent à nouveau accumuler les charges générées sous l'effet de la lumière à laquelle elles sont exposées. L'évacuation des charges peut être obtenue en rendant conducteur simultanément, le temps de l'impulsion d'initialisation, le transistor de transfert et le transistor de ré-initialisation du nœud de lecture. Les charges sont alors évacuées vers le drain du transistor de réinitialisation. Mais on préfère généralement utiliser un cinquième transistor spécifique, dont la source est reliée à la photodiode du pixel, et les charges sont évacuées vers le drain de ce transistor.
- on rend conducteur tous les transistors de transfert simultanément, le temps d'une impulsion de commande appliquée sur leur grille : les charges générées et accumulées par chaque photodiode depuis le début de la durée d'intégration courante, se déversent dans le nœud de lecture associé. C'est la fin de cette impulsion de commande de transfert qui fixe la fin de la durée d'intégration pour tous les pixels.

Après chaque durée d'intégration, la phase de lecture des pixels peut commencer. C'est une lecture séquentielle, ligne par ligne. Pour chacun des pixels d'une ligne on rend conducteur le transistor de sélection du pixel, le temps d'une impulsion de commande de sélection, et dans ce temps :
- on échantillonne le niveau de signal qui s'établit sur le conducteur de colonne dans le circuit de lecture en pied de colonne du pixel ; puis
- on rend conducteur, le temps d'une impulsion de commande d'initialisation, le transistor de ré-initialisation du nœud de lecture et on échantillonne dans le circuit de lecture le niveau de référence qui s'établit sur le conducteur de colonne.

Le circuit de lecture peut alors fournir en sortie une mesure de la différence entre le niveau de signal et le niveau de référence. Mais ce niveau n'est pas une mesure précise de la quantité de charges générées dans la photodiode car le bruit aléatoire dit kTC n'est pas éliminé. En effet, ce bruit est généré par la réinitialisation du nœud de lecture par le transistor de réinitialisation et se traduit par le fait que le potentiel auquel le nœud de lecture s'établit n'est pas tout à fait certain.

Pour pouvoir éliminer cette incertitude, dans le but d'améliorer la dynamique des capteurs vers les bas niveaux de lumière, il faut que le niveau de signal soit établi sur le nœud de lecture après sa réinitialisation, pour que ce niveau de signal prenne en compte cette incertitude. C'est-à-dire qu'il faut d'abord initialiser le nœud de lecture, échantillonner le niveau de potentiel de référence correspondant, puis établir le niveau de signal (transfert) pour ensuite échantillonner le niveau de signal. On parle de lecture à double échantillonnage corrélé, dit "CDS". Avec une structure à quatre ou cinq transistors telle que présentée, on ne sait faire cela qu'avec un mode d'intégration de type "rolling shutter". On ne sait pas le faire en mode d'intégration de type "global shutter".

C'est ainsi qu'on a pu proposer dans l'art antérieur des structures comportant un nœud mémoire entre la photodiode et le nœud de lecture. Le nœud mémoire va permettre de conserver les charges générées par la photodiode après chacune des durées d'intégration communes à tous les pixels, le temps dans chaque ligne de pixels, d'initialiser le nœud de lecture des pixels, d'échantillonner le niveau de référence correspondant dans le circuit de lecture de chacun des pixels de la ligne, puis de déverser les charges du nœud mémoire dans le nœud de lecture et d'échantillonner le niveau de signal dans le circuit de lecture. Ces structures à étage mémoire intermédiaire permettent ainsi d'utiliser la technique de capture dite "global shutter" et un double échantillonnage corrélé, permettant la mesure précise de la quantité de charges générées dans la photodiode du pixel pour la durée d'intégration concernée. En pratique on prévoit alors deux transistors (ou grilles) de transfert, un premier entre la photodiode et le nœud mémoire, et un deuxième entre le nœud mémoire et le nœud de lecture. Le premier transistor de transfert entre la photodiode et le nœud mémoire est alors celui qui commande la fin de chaque durée d'intégration pour tous les pixels en même temps, fin qui coïncide avec la fin de l'impulsion de commande de transfert dans le nœud mémoire. Le deuxième transistor de transfert sert dans la phase de lecture de ligne de pixels.

La publication US 2014/0247378 propose une autre utilisation de la structure de pixel à nœud mémoire, pour ajuster la durée d'exposition des photodiodes par exemple en fonction de la couleur des pixels et de l'intensité lumineuse. Il s'agit de commander une ou plusieurs sous-périodes d'exposition des photodiodes pendant la durée de chaque cycle d'acquisition. La durée de chaque sous-période est une fraction de la durée du cycle, et la durée réelle d'exposition, pendant laquelle le pixel accumule des charges, est égale à la somme des durées des sous-périodes du pixel et inférieure à la durée du cycle.

Dans l'invention on s'intéresse à ces structures de pixels actifs qui comportent un nœud mémoire entre la photodiode et le nœud de lecture adaptées à la fonction de lecture à double échantillonnage corrélé. Ces structures dont on trouve des exemples dans les publications FR2961631, JP20063115150, permettent à la fois de commander la capture d'image par tous les pixels simultanément dans la même durée d'intégration (fonction "global shutter") et effectuer une lecture "CDS" des pixels, ligne par ligne.

Ces structures offrent une dynamique vers le bas qui est optimisée, puisqu'elles sont à faible bruit de lecture (lecture CDS).

En présence de forte lumière, il y a cependant un risque de saturation de la photodiode, ce qui limite la dynamique vers le haut. Or la capacité de stockage maximum des photodiodes dépend de la surface occupée par la photodiode, qui elle détermine la taille du pixel. On ne cherche pas à l'augmenter ; la tendance est même plutôt à la diminuer, et à compenser la perte d'ouverture par l'utilisation de microlentilles pour concentrer la lumière sur les photodiodes des pixels.

### RESUME DE L'INVENTION

Selon l'invention, pour améliorer la dynamique vers le haut de ces capteurs, on propose d'adopter les deux mesures suivantes :
- d'une part on prévoit que la capacité de stockage des charges du nœud mémoire est au moins N fois supérieure à la capacité de stockage de charges de la photodiode (N entier supérieur ou égal à 2) ;
- d'autre part on prévoit de faire N transferts de charge de la photodiode vers le nœud mémoire régulièrement espacés sur la durée d'intégration.

Il est en général facile de prévoir un nœud mémoire ayant une capacité de stockage plusieurs fois supérieure à la capacité de stockage de la photodiode sans que cela aboutisse à une réduction trop importante de l'ouverture optique du pixel. En effet, le nœud mémoire peut être réalisé par une grille isolée, dont la capacité par unité de surface est très supérieure à la capacité par unité de surface de la photodiode.

L'invention concerne ainsi un procédé de prise d'image dans un capteur à pixels actifs comprenant au moins une ligne de pixels actifs, dans lequel les pixels actifs comprennent chacun un élément photosensible, un nœud de lecture et un nœud mémoire entre l'élément photosensible et le nœud de lecture, et au moins un premier transistor de transfert de charges entre l'élément photosensible et le nœud mémoire, un deuxième transistor de transfert de charges entre le nœud mémoire et le nœud de lecture, un transistor de ré-initialisation du nœud de lecture, un transistor suiveur ayant sa grille reliée au nœud de lecture et un transistor de sélection du pixel qui est connecté entre la source du transistor suiveur et un conducteur de colonne, le procédé de prise d'image étant tel que chaque cycle d'intégration et lecture comprend une réinitialisation simultanée de tous les éléments photosensibles par vidage de charges des éléments photosensibles dans un drain d'évacuation, une intégration de charges dans les éléments photosensibles pendant une durée d'intégration commune qui commence à la fin de la réinitialisation de tous les éléments photosensibles, un transfert de charges du nœud mémoire vers le nœud de lecture après la fin de la durée d'intégration commune et une lecture des charges contenues dans le nœud mémoire par double-échantillonnage corrélé, successivement pour chaque ligne, après la fin de la durée d'intégration commune. Pour chaque cycle d'intégration et lecture, le procédé de prise d'image comprend N transferts de charges de l'élément photosensible vers le nœud mémoire, régulièrement espacés pendant la durée d'intégration commune, N entier supérieur ou égal à 2, l'élément photosensible accumulant des charges sur toute la durée d'intégration commune, le nœud mémoire étant configuré avec une capacité de stockage de charges qui est au moins N fois celle de l'élément photosensible, les N transferts étant commandés par application à intervalles réguliers pendant ladite durée d'intégration commune, de N impulsions de commande sur la grille du premier transistor de transfert, et la fin du Nième transfert fixant la fin de la durée d'intégration commune.

De préférence, le nœud de lecture a au moins N fois la capacité de stockage de charges de l'élément photosensible.

De préférence N est choisi égal à 2 ou 3.

D'autres caractéristiques et avantages de l'invention sont présentés dans la description suivante, en référence aux dessins annexés dans lesquels :
- la figure 1 illustre une structure générale de pixel actif à laquelle l'invention peut s'appliquer ;
- la figure 2 est un chronogramme des signaux de commande d'un pixel actif suivant un procédé de prise d'image selon l'invention.
- les figures 3a à 3d montre les diagrammes des potentiels dans la structure du pixel correspondant à différentes étapes a) à d) de la durée d'intégration ; et
- les figures 4a à 4c montre les diagrammes des potentiels dans la structure du pixel correspondant à différentes étapes a') à c') de la phase de lecture,

### DESCRIPTION DETAILLEE

Les pixels actifs sont réalisés en technologie CMOS dans une couche active semi-conductrice dopée (par exemple dopée P) et comprennent en plus des photodiodes, qui sont en principe des photodiodes autopolarisées dites "pinned", des nœuds de stockage capacitifs et des transistors. Leurs réalisations utilisent les diverses technologies CMOS bien connues de l'homme de l'art.

Pour les explications, on se place dans le contexte d'un substrat de couche active semi-conductrice dopée P, polarisé à un potentiel de référence zéro et dont les circuits sont alimentés par une tension d'alimentation positive, notée Vdd. L'homme du métier sait qu'il faudrait inverser les polarisations si l'on se plaçait dans le contexte d'un substrat de couche active semi-conductrice dopée N.

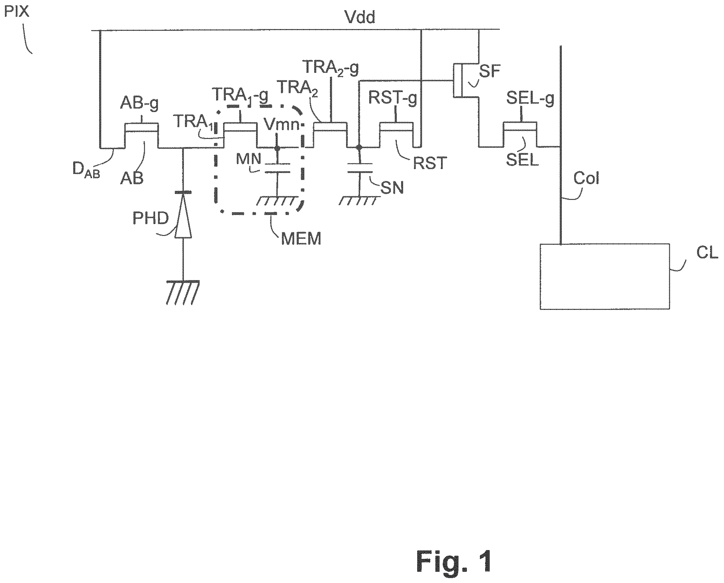

La figure 1 est un schéma électrique d'une structure générale de pixel actif à élément photosensible, nœud mémoire et nœud de lecture, à laquelle l'invention peut s'appliquer. Dans cet exemple, le pixel PIX comprend une photodiode PHD, un premier nœud de stockage capacitif appelé nœud mémoire et noté MN, un deuxième nœud de stockage capacitif appelé nœud de lecture et noté SN et au moins 5 transistors qui sont :
- un premier transistor de transfert TRA₁ (en pratique une simple grille de transistor), permettant de déverser des charges de la photodiode PHD vers le nœud mémoire MN.
- un deuxième transistor de transfert TRA₂ (en pratique une simple grille de transistor), permettant de vider le nœud mémoire MN dans le nœud de lecture.
- un transistor de ré-initialisation RST du nœud de lecture SN, dont la source est électriquement reliée au nœud de lecture et le drain est relié à la tension d'alimentation positive Vdd.
- un transistor suiveur SF, dont la grille est électriquement reliée au nœud de lecture SN, et le drain est polarisé à la tension d'alimentation Vdd.
- un transistor de sélection SEL qui reçoit sur sa grille une commande de sélection de la ligne du pixel, dont le drain est électriquement relié à la source du transistor suiveur et dont la source est reliée à un conducteur de colonne (Col) de la matrice (les pixels étant organisés matriciellement en lignes de pixels et colonnes de pixels), chaque conducteur de colonne étant relié en pied de colonne, à un circuit de lecture CL commun à tous les pixels de la colonne.

Il peut comprendre un sixième transistor AB, qui permet l'initialisation de la photodiode, en permettant l'évacuation des charges par son drain. Un intérêt de ce sixième transistor est qu'il permet une fonction dite d'anti-éblouissement, c'est-à-dire qu'en polarisant sa grille à une tension déterminée sous le seuil de conduction de transistor, on peut ajuster le potentiel de la barrière de la région semi-conductrice sous la grille, à un niveau qui permet l'évacuation des charges en excès dans la photodiode, par le drain du transistor. Quand il n'est pas prévu l'initialisation des photodiodes est obtenue en activant ensemble dans chaque pixel, les transistors TRA₁, TRA₂ et RST.

On notera que certains transistors du pixel peuvent être en pratique partagés entre au moins deux pixels, ce qui peut être intéressant lorsque l'on cherche à réaliser des petits pixels avec un fort facteur de remplissage. Par exemple, le transistor suiveur et le transistor de sélection de ligne sont partagés entre deux ou quatre pixels d'une même colonne. Le transistor d'initialisation de la photodiode peut également être partagé entre au moins deux pixels. On réduit alors la surface de couche active nécessaire à la commande des pixels. L'invention s'applique aussi bien à ces structures de pixels à transistors partagés.

La photodiode PHD est habituellement une photodiode autopolarisée à une tension notée Vₚᵢₙ définie par la technologie, c'est-à-dire qu'elle comporte sur la région diffusée de type N, une région diffusée superficielle de type P et la région superficielle est portée au potentiel de référence (zéro) du substrat.

Le nœud de lecture SN, qui est l'équivalent d'une capacité, est en pratique constitué par une région semi-conductrice dopée N à potentiel flottant. La capacité de stockage des charges du nœud de lecture correspond au moins à celle de la photodiode. Cette capacité dépend notamment de la concentration de dopants et de la géométrie du nœud mémoire.

Le nœud mémoire MN est l'équivalent d'une capacité pour stocker les charges générées et accumulées par la photodiode à la fin d'une période d'intégration. En pratique ce nœud mémoire n'est pas une diffusion flottante comme le nœud de lecture. On doit en effet pouvoir fixer son potentiel à un niveau déterminé qui doit être supérieur à la tension Vₚᵢₙ de photodiode, au moins dans la phase de transfert des charges de la photodiode vers le nœud mémoire ; et qui doit être inférieur à la tension d'alimentation Vdd, au moins dans la phase de transfert des charges du nœud mémoire vers le nœud de lecture. Son potentiel peut donc être variable, suivant la phase concernée, c'est-à-dire selon que le nœud mémoire est la source ou la destination des charges transférées. Mais il peut aussi être fixe. Dans la suite de l'explication, et dans les dessins c'est cette option (potentiel fixe) qui est représentée, pour plus de simplicité.

Par exemple, le nœud mémoire est une région semiconductrice surmontée d'une grille, et cette grille est polarisée à un potentiel qui permet d'établir la région semi-conductrice de nœud mémoire sous la grille à un niveau de potentiel déterminé entre le niveau Vₚᵢₙ de la photodiode et Vdd. La capacité de stockage de charges sous cette grille dépend alors de la capacité de grille (donc de sa géométrie), de la concentration de dopants ...etc. On trouve d'autres exemples de réalisation du nœud mémoire dans l'art antérieur des pixels dits à (au moins) six transistors. Par exemple les publications de brevet WO2006130443, US598629, ou FR2961631.

Dans un exemple où le substrat est de type P, ces différents transistors seront de type NMOS, c'est-à-dire avec des régions de source et de drain qui sont des diffusions de type N de part et d'autre d'un canal de type P, sous la grille.

Cette appellation "transistor" est utilisée pour faciliter la compréhension en termes de schéma électrique tel que le schéma de la figure 1. Toutefois, dans la constitution physique du pixel, ces transistors ne sont pas nécessairement tous constitués de manière classique, indépendamment des autres éléments du pixel, avec une région de source, une région de drain, une région de canal séparant la source du drain et une grille isolée au-dessus du canal. Dans la constitution physique réelle du pixel, certains transistors sont en réalité constitués essentiellement par une grille isolée à laquelle on peut appliquer un potentiel de commande. Ainsi, par exemple, le premier transistor de transfert TRA₁ sera t-il constitué par une simple grille de transfert TRA₁-g isolée du substrat, surmontant une région de canal de type P qui est située entre la région N de photodiode PHD (source de TRA₁) et la région N du nœud mémoire NM (drain de TRA₁). De même : la source du deuxième transistor de transfert TRA₂ peut être la région N du nœud mémoire NM, et le drain de ce transistor TRA₂ peut être la région N du nœud de lecture SN. Egalement la source du transistor AB d'initialisation peut-être la région N de la photodiode qui accumule des charges générées par la lumière ; et la source du transistor RST peut être la région N du nœud de lecture.

L'invention ne porte pas sur une technologie particulière de pixel actif, mais bien sur l'utilisation d'une structure de pixel actif à photodiode, nœud de lecture et nœud mémoire entre la photodiode et nœud de lecture, par exemple, une structure comme décrit ci-dessus avec ou sans transistor d'anti-éblouissement AB. Egalement, la structure de pixel actif peut comprendre un ou des transistors partagés avec au moins un autre pixel.

Dans l'invention, on prévoit pour commander le pixel actif, les deux mesures suivantes :
- la capacité de stockage des charges du nœud mémoire est au moins N fois supérieure à la capacité de stockage de charges de la photodiode (N entier supérieur ou égal à 2) ; et
- on effectue N transferts de charge de la photodiode vers le nœud mémoire, régulièrement espacés, pendant chaque durée d'intégration au cours d'un cycle périodique d'intégration et lecture de charges.

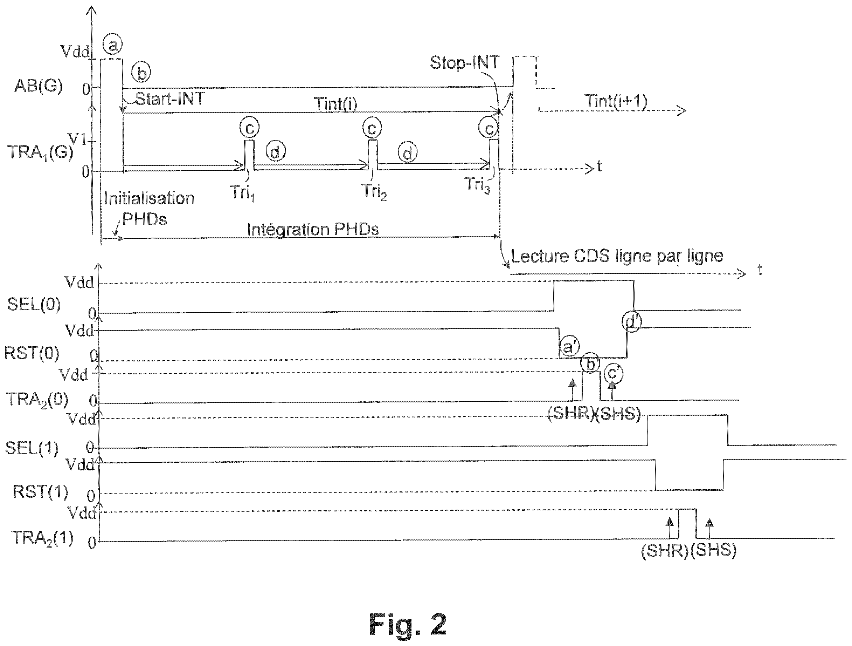

Ainsi, comme illustré par le chronogramme de la figure 2 dans un exemple où N est égal à 3, après le début de la durée d'intégration Tint(i) d'un ième cycle d'intégration et lecture, fixé par le front descendant de l'impulsion de commande de grille AB-g du transistor AB d'initialisation de la photodiode, on applique successivement, à intervalles réguliers, N=3 impulsions de commande Tri₁, Tri₂ et Tri₃ sur la grille TRA₁-g du premier transistor de transfert, TRA₁. Et le front descendant de la dernière (Nième) impulsion Tri₃ marque la fin de la durée d'intégration courante Tint(i).

De cette façon, en cas de forte ambiance de lumière, comme les charges sont transférées en plusieurs fois au cours de la période d'intégration, la photodiode va être capable de continuer à accumuler des charges sur toute la durée de l'intégration ; les charges s'additionnent dans le nœud mémoire à chaque transfert. Les transferts sont réalisés à intervalles réguliers, répartis équitablement sur la durée d'intégration Tint. C'est-à-dire, dans cet exemple où N=3, on a sensiblement le même intervalle de temps entre le début d'intégration et le 1^{er} transfert, entre le 1^{er} et le 2^{ième} transfert et entre le 2^{ième} et le 3^{ième} transfert.

Les deux mesures de l'invention permettent un procédé de commande des pixels qui a comme effet technique de multiplier par N la capacité d'accumulation de charges dans chaque pixel sur la durée de la période d'intégration pour une capacité donnée de la photodiode. Mais cette accumulation ne se fait pas dans la photodiode. Dans l'invention cette accumulation se fait dans le nœud mémoire, par le fait du déversement à intervalles réguliers des charges de la photodiode dans ce nœud mémoire sur toute la durée d'intégration. Comme indiqué précédemment, on n'a pas les mêmes limitations technologiques pour le nœud mémoire que pour la photodiode : on sait donc réaliser un nœud mémoire avec la capacité de stockage voulue, au moins égale à N fois la capacité de la photodiode, sans pénaliser la taille du pixel.

Le nœud de lecture a lui aussi, de préférence, une capacité au moins égale à N fois celle de la photodiode.

De préférence, N est égal à 2 ou 3.

Un capteur à pixels actifs ayant la structure (électrique) générale de la figure 1 est spécialement adapté à un procédé de prise d'image utilisant une durée d'intégration commune à tous les pixels (*"global shutter"*), avec une lecture des pixels ligne par ligne, qui est une lecture à double échantillonnage corrélé, dite lecture CDS par le circuit de lecture en pied de chaque colonne.

Le procédé de commande selon l'invention, qui utilise un nœud mémoire dont la capacité est au moins N fois celle de la photodiode est particulièrement adapté et avantageux pour un tel procédé de prise d'image.

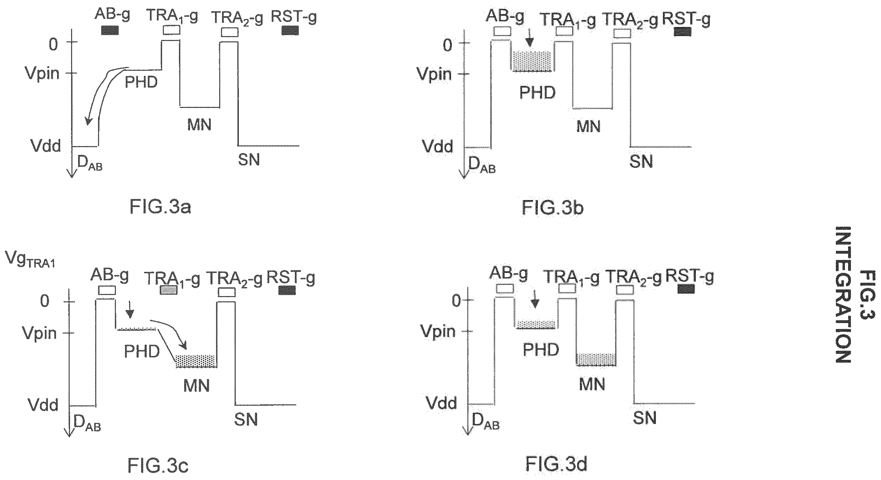

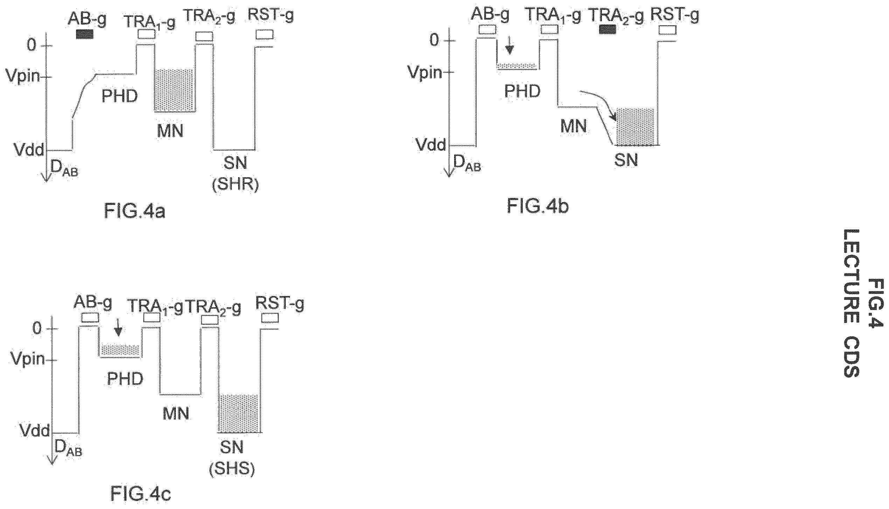

Un tel procédé de prise d'image est maintenant décrit en s'appuyant sur le chronogramme des signaux de commande des transistors représenté sur la figure 2 et des diagrammes des potentiels des figures 3 et 4. Dans ces figures 3 et 4, la valeur du potentiel des différentes grilles représentées par un rectangle, est indiquée par la couleur de fond de ce rectangle : blanc=zéro ; noir=VDD ; gris= potentiel intermédiaire. Egalement, pour faciliter la compréhension, les étapes et les figures 3 ou 4 qui correspondent aux étapes sont référencées par une même lettre. On notera enfin que les chronogrammes et représentation de barrière de potentiels des figures 2 à 4 correspondent à un contexte de capteur réalisé à couche active de type P. L'homme du métier saura transposer à un contexte de capteur à couche active N.

On part d'un état initial (non représenté sur les figures 3 et 4) dans lequel les transistors sont tous à l'état non conducteur.

Chaque cycle périodique d'intégration et lecture comprend une durée d'intégration Tint commune à tous les pixels, puis une lecture "CDS" des pixels, ligne par ligne.

Comme illustré sur la figure 2, chaque cycle d'intégration et lecture commence par une étape a) d'initialisation de toutes les photodiodes simultanément. Un diagramme correspondant des potentiels dans la structure est illustré par la figure 3a.

Dans cette étape, on applique une impulsion de commande d'initialisation AB(G) simultanément sur la grille AB-g de tous les transistors AB d'initialisation : ils sont alors fortement conducteurs et vident la photodiode associée de toutes charges, par le drain D_{AB} de ce transistor. Dans une structure sans transistor d'anti-éblouissement AB, on initialiserait les photodiodes en rendant simultanément conducteurs, le temps de l'impulsion d'initialisation, les premier et deuxième transistors de transfert et le transistor de ré-initialisation du nœud de lecture. Les charges seraient alors évacuées vers le drain du transistor de réinitialisation.

La fin de l'impulsion d'initialisation commune AB(G), fait repasser les transistors AB à l'état non conducteur et fixe le début Start-INT de la durée d'intégration Tint(i) pour toutes les photodiodes PHD simultanément : elles peuvent à ce moment à nouveau accumuler les charges générées sous l'effet de la lumière à laquelle elles sont exposées. C'est l'étape b) illustrée sur les figures 2 et 3b.

L'étape c) suivante (Figures 2 et 3c) consiste à appliquer par le signal de commande TRA1(G) appliqué à toutes les grilles TRA₁-g des pixels, une première impulsion de commande Tri₁ : les premiers transistors de transferts TRA₁ sont à ce moment fortement conducteurs et les charges générées et accumulées par chaque photodiode depuis le début Start-INT de la durée d'intégration courante, se déversent dans le nœud mémoire associé. Dans l'exemple, le niveau de tension correspondant à l'état actif de l'impulsion de commande Tri₁ est un niveau V1 intermédiaire entre 0 et Vdd, pour abaisser la barrière de potentiel de la région semi-conductrice sous la grille TRA₁-g à un niveau qui permet le déversement des charges de la photodiode dans le nœud mémoire.

A la fin de l'impulsion de commande Tri₁, la photodiode recommence à accumuler les charges : c'est l'étape d) (Figures 2 et 3d), jusqu'à la prochaine impulsion de commande Tri₂.

Ainsi les étapes c) et d) s'appliquent à tous les pixels simultanément et se répètent successivement jusqu'à la Nième impulsion de transfert, qui est la 3^{ieme} impulsion Tri₃ dans l'exemple illustré à la figure 2 : la fin de cette N-ième impulsion marque la fin Stop-INT de la durée d'intégration courante Tint(i).

Une nouvelle durée d'intégration Tint(i+1) d'un nouveau cycle périodique (d'intégration puis lecture) pourra commencer, reprenant les étapes a, b, c, d décrites ci-dessus.

Avec la fin Stop-INT de la durée d'intégration courante Tint(i), la phase suivante de lecture des pixels peut commencer. C'est une lecture séquentielle, ligne par ligne. La sélection des pixels d'une ligne consiste à appliquer une impulsion de commande de sélection sur la grille SEL-g du transistor de sélection SEL des pixels (Figure 2 : commande SEL(0) pour la première ligne de rang 0), ce qui a pour effet pour chaque pixel de la ligne sélectionnée de relier électriquement la source du transistor suiveur SF du pixel au conducteur de colonne et donc au circuit de lecture CL correspondants, le temps de cette impulsion de sélection. La lecture CDS des pixels de la ligne sélectionnée est effectuée dans ce temps de sélection, et comprend la suite d'étapes a') à d') suivantes :
- a') la grille RST-g du transistor de ré-initialisation du nœud de lecture des pixels de la ligne sélectionnée est tirée au potentiel zéro (Figure 2 : signal de commande RST(0) à zéro pour la ligne de rang 0), cette grille étant maintenue à Vdd sinon. Le potentiel du conducteur colonne s'établit alors un niveau de référence que l'on échantillonne dans le circuit de lecture en pied de colonne. Cet échantillonnage est représenté sur les Figures 2 et 4a par la commande SHR.
- b') on rend conducteur le deuxième transistor de transfert TRA₂ des pixels de la ligne sélectionnée, le temps d'une impulsion de commande de niveau Vdd, appliquée sur leur grille TRA₂-g (signal TRA₂(0) pour la ligne sélectionnée de rang 0 - Figure 2), permettant le transfert des charges du nœud mémoire dans le nœud de lecture (Figures 2 et 4b).

- c') à la fin de cette impulsion de transfert, le potentiel du conducteur de colonne s'établit à un niveau de signal représentatif de la quantité de charges dans le nœud de lecture, et ce niveau de signal est échantillonné dans le circuit de lecture en pied de colonne (SHS, Figures 2 et 4c).
- d') La grille RST-g du transistor est ramenée au potentiel Vdd (RST(0)=Vdd) puis la ligne est désélectionnée (fin de l'impulsion de sélection SEL(0) - Figure 2).

Les étapes a' à d' s'appliquent simultanément à tous les pixels de la ligne sélectionnée.

La séquence des étapes a') et d') de lecture se répète pour chacune des lignes de pixels successivement, comme illustré sur la figure 2 pour la ligne suivante de rang 1, avec les signaux de commande correspondants SEL(1), RST(1) et TRA₂(1).

En même temps que la phase de lecture suivant une durée d'intégration Tint(i) se déroule, ou après cette phase de lecture, une nouvelle durée d'intégration (Tint(i+1)) d'un cycle d'intégration et lecture suivant peut démarrer.

Cependant, la lecture de toutes les lignes doit être terminée avant la première impulsion de transfert Tri1 produite après une durée Tint(i+1)/N suivant le début de la durée d'intégration suivante Tint(i+1).

L'invention qui vient d'être décrite permet d'améliorer la dynamique d'un pixel actif à nœud mémoire intermédiaire entre l'élément photosensible et le nœud de lecture, en s'affranchissant des contraintes technologiques, sans augmenter la surface de l'élément photosensible. On peut même envisager de diminuer cette surface d'élément photosensible en compensant la perte de facteur de remplissage par l'utilisation d'une microlentille sur chaque pixel pour concentrer la lumière vers la surface photosensible du pixel.

L'invention est particulièrement avantageuse pour les capteurs miniaturisés si on envisage en outre de la mettre en œuvre avec des technologies de nœud mémoire qui offrent une capacité par unité de surface qui est intrinsèquement plus grande que celle permise par les technologies des photodiodes "pinned".

## Revendications

1. Procédé de prise d'image dans un capteur à pixels actifs comprenant au moins une ligne de pixels actifs, dans lequel les pixels actifs comprennent chacun un élément photosensible (PHD), un nœud de lecture (SN) et un nœud mémoire (MN) entre l'élément photosensible et le nœud de lecture, et au moins un premier transistor de transfert de charges (TRA₁) entre l'élément photosensible et le nœud mémoire, un deuxième transistor de transfert de charges (TRA₂) entre le nœud mémoire et le nœud de lecture, un transistor de ré-initialisation (RST) du nœud de lecture, un transistor suiveur (SF) ayant sa grille reliée au nœud de lecture et un transistor de sélection (SEL) du pixel qui est connecté entre la source du transistor suiveur et un conducteur de colonne (Col), le procédé de prise d'image étant tel que chaque cycle d'intégration et lecture comprend une initialisation simultanée de tous les éléments photosensibles par vidage de charges des éléments photosensibles dans un drain d'évacuation (D_{AB}), une intégration de charges dans les éléments photosensibles pendant une durée d'intégration commune qui commence à la fin de l'initialisation de tous les éléments photosensibles, un transfert de charges du nœud mémoire vers le nœud de lecture après la fin de la durée d'intégration commune et une lecture des charges contenues dans le nœud mémoire par double-échantillonnage corrélé, successivement pour chaque ligne, après la fin de la durée d'intégration commune,
**caractérisé en ce que** pour chaque cycle d'intégration et lecture, le procédé de prise d'image comprend N transferts de charges de l'élément photosensible vers le nœud mémoire, régulièrement espacés pendant la durée d'intégration commune, N entier supérieur ou égal à 2, l'élément photosensible accumulant des charges sur toute la durée d'intégration commune, le nœud mémoire étant configuré avec une capacité de stockage de charges qui est au moins N fois celle de l'élément photosensible, les N transferts étant commandés par application à intervalles réguliers pendant ladite durée d'intégration commune, de N impulsions de commande (Tri₁, Tri₂, Tri₃) sur la grille (TRA₁-g) du premier transistor de transfert, et la fin du Nième transfert fixant la fin de la durée d'intégration commune.

2. Procédé de prise d'image selon la revendication 1, dans lequel le nœud de lecture a au moins N fois la capacité de stockage de charges de l'élément photosensible.

3. Procédé de prise d'image selon la revendication 1 ou 2, dans lequel N est égal à 2 ou 3.

## Patentansprüche

1. Bildgebungsverfahren in einem Sensor mit aktiven Pixeln, umfassend wenigstens eine Reihe von aktiven Pixeln, in dem die aktiven Pixel jeweils Folgendes umfassen: ein fotoempfindliches Element (PHD), einen Leseknoten (SN) und einen Speicherknoten (MN) zwischen dem fotoempfindlichen Element und dem Leseknoten, und wenigstens einen ersten Ladungsübertragungstransistor (TRA₁) zwischen dem fotoempfindlichen Element und dem Speicherknoten, einen zweiten Ladungsübertragungssensor (TRA₂) zwischen dem Speicherknoten und dem Leseknoten, einen Neuinitialisierungstransistor (RST) des Leseknotens, einen Folgetransistor (SF), dessen Gate mit dem Leseknoten verbunden ist, und einen Auswahltransistor (SEL) des Pixels, der zwischen der Source des Folgetransistors und einem Spaltenleiter (Col) geschaltet ist, wobei das Bildgebungsverfahren derart ist, dass jeder Integrations- und Lesezyklus Folgendes beinhaltet: eine gleichzeitige Initialisierung aller fotoempfindlichen Elemente durch Entleeren von Ladungen der fotoempfindlichen Elemente in einem Evakuierungs-Drain (D_{AB}), eine Ladungsintegration in den fotoempfindlichen Elementen während einer gemeinsamen Integrationsdauer, die am Ende der Initialisierung aller fotoempfindlichen Elemente beginnt, eine Übertragung von Ladungen des Speicherknotens zum Leseknoten nach dem Ende der gemeinsamen Integrationsdauer und ein Lesen von in dem Speicherknoten enthaltenen Ladungen durch korrelierte Doppelabtastung, Zeile für Zeile, nach dem Ende der gemeinsamen Integrationsdauer,
**dadurch gekennzeichnet, dass** für jeden Integrations- und Lesezyklus das Bildgebungsverfahren N Ladungsübertragungen des fotoempfindlichen Elements zu dem Speicherknoten umfasst, gleichmäßig während der gemeinsamen Integrationsdauer beabstandet, wobei N eine ganze Zahl gleich oder größer als 2 ist, wobei das fotoempfindliche Element Ladungen über die gesamte gemeinsame Integrationsdauer akkumuliert, wobei der Speicherknoten mit einer Ladungsspeicherkapazität konfiguriert ist, die wenigstens das N-fache von der des fotoempfindlichen Elements beträgt, wobei die N Übertragungen durch Anwenden, in regelmäßigen Intervallen während der gemeinsamen Integrationsdauer, von N Steuerimpulsen (Tri₁, Tri₂, Tri₃) auf das Gate (TRA₁-g) des ersten Übertragungstransistors gesteuert werden, und das Ende der N-ten Übertragung das Ende der gemeinsamen Integrationsdauer festlegt.

2. Bildgebungsverfahren nach Anspruch 1, bei dem der Leseknoten wenigstens das N-fache der Ladungsspeicherkapazität des fotoempfindlichen Elements hat.

3. Bildgebungsverfahren nach Anspruch 1 oder 2, bei dem N gleich 2 oder 3 ist.

## Claims

1. Method for taking images in an active-pixel sensor comprising at least one row of active pixels, in which the active pixels each comprise a photosensitive element (PHD), a read-out node (SN) and a memory node (MN) between the photosensitive element and the read-out node, and at least one first charge-transfer transistor (TRA₁) between the photosensitive element and the memory node, one second charge-transfer transistor (TRA₂) between the memory node and the read-out node, one transistor (RST) for resetting the read-out node, one follower transistor (SF) having its gate connected to the read-out node and one pixel-selection transistor (SEL) that is connected between the source of the follower transistor and a column conductor (Col), the image-taking method being such that each integration and read-out cycle comprises a simultaneous initialization of all the photosensitive elements by evacuation of charge of the photosensitive elements in an evacuation drain (D_{AB}), an integration of charge in the photosensitive elements during a common integration duration which starts at the end of said initialization of all the photosensitive elements, a transfer of charge from the memory node to the read-out node after the end of the common integration duration and read-out of the charge contained in the memory node by correlated double sampling read-out successively for each row, after the end of the common integration duration,
**characterized in that**, for each integration and read-out cycle, the image-taking method comprises N transfers of charge of the photosensitive element to the memory node, regularly spaced during de common integration duration, N being an integer higher than or equal to 2, the photosensitive element accumulating charge throughout said common integration duration, the memory node being configured to have a charge-storage capacity that is at least N times that of the photosensitive element, the N transfers being commanded by applying, at regular intervals during said common integration duration, N control pulses (Tri₁, Tri₂, Tri₃) to the gate (TRA₁-g) of the first transfer transistor, and the end of the Nth transfer setting the end of the common integration duration.

2. Image-taking method according to claim 1, wherein the read-out node has at least N times the charge-storage capacity of the photosensitive element.

3. Image-taking method according to claim 1 or 2, wherein N is equal to 2 or 3.
